# EUROPEAN PATENT APPLICATION

(11) **EP 4 722 413 A1**
(43) Date of publication of application: **08.04.2026**
(21) Application number: 24204286.9
(22) Date of filing: 02.10.2024
(51) Int. Cl.: C23C 28/00, C23C 14/02, C23C 14/06, C23C 14/32, C23C 14/58, C23C 30/00, F16J 9/26

(54) **SLIDING ELEMENT FOR USE IN AN INTERNAL COMBUSTION ENGINE, AND METHOD FOR PREPARING THE SLIDING ELEMENT**

(71) Applicant: Mahle International GmbH, 70376 Stuttgart (DE)
(72) Inventor: Avelar Araujo, Juliano, 3040-382 Coimbra (PT)

(57) **Abstract**

The invention relates to a sliding element for use in an internal combustion engine, comprising a metallic base which is at least partly covered with a protective coating, with the protective coating comprising at least one adhesive layer and at least one functional layer, characterized in that:
(iv) the at least one adhesive layer is situated between the metallic base and the at least one functional layer,
(v) the at least one adhesive layer comprises at least one metal, and
the at least one functional layer comprises or consists of an alloy of nitrides, the alloy of nitrides comprising or consisting of a nitride solid solution and a nitride-containing multicomponent alloy, wherein the nitride solid solution comprises, based on the total nitride solid solution, at least about 35 at-% of Chromium and at least about 40 at-% of Nitrogen, and wherein the nitride-containing multicomponent alloy is a high-entropy alloy comprising at least about 40 at-% of Nitrogen based on the total nitride-containing multicomponent alloy, and at least four elements selected from the group consisting of Cr, Al, Si, W, Mo, Zr, Ti, Ni, Fe, Co, Nb, Ce, and B.

## Description

The present invention relates to a sliding element for use in an internal combustion engine, such as, for example, a piston ring, provided with a coating that comprises at least one functional layer as well as a method for preparing the sliding element and an internal combustion engine comprising at least one of the sliding elements according to the category of the independent claims.

In order to provide the high durability required for sliding components such as piston rings for internal combustion engines, which are exposed to endless operating cycles, high temperatures and chemical and abrasive influences during operation, such sliding elements are often provided with a coating. Currently, such coatings are usually based on chromium nitride. For instance, DE 10 2009 046 281 B3 discloses a sliding element comprising a CrN layer as well as a DLC layer which is at least in part metal-free.

However, a disadvantage, for instance of the use of chromium nitride monolayers, is that during the use in high loaded engines with high combustion pressure, such films show a certain brittleness. This may lead to micro fractures, which are responsible for the detachment of small parts of the coating, for instance in the case of piston rings causing scratches to the cylinder liner surface. Furthermore, in conventional coatings also the adhesive resistance during increasing internal stress has been an issue.

The objective of the present invention is to provide a sliding element for use in an internal combustion engine as well as a method for preparing such sliding element providing a good wear resistance as well as a good spalling resistance of the coating. A further object of the present invention is to provide an internal combustion engine comprising at least one of the sliding elements of the invention.

According to the invention, this object is achieved by the subject of the independent claims. Advantageous embodiments are subject of the dependent claims.

According to the present invention, a sliding element for use in an internal combustion engine is provided, comprising a metallic base which is at least partly covered with a protective coating, with the protective coating comprising at least one adhesive layer and at least one functional layer, characterized in that:
(i) the at least one adhesive layer is situated between the metallic base and the at least one functional layer,
(ii) the at least one adhesive layer comprises at least one metal, and
(iii) the at least one functional layer comprises or consists of an alloy of nitrides, the alloy of nitrides comprising or consisting of a nitride solid solution and a nitride-containing multicomponent alloy, wherein the nitride solid solution comprises, based on the total nitride solid solution, at least about 35 at-% of Chromium and at least about 40 at-% of Nitrogen, and wherein the nitride-containing multicomponent alloy is a high-entropy alloy comprising at least about 40 at-% of Nitrogen based on the total nitride-containing multicomponent alloy, and at least four elements selected from the group consisting of Cr, Al, Si, W, Mo, Zr, Ti, Ni, Fe, Co, Nb, Ce, and B.

It has surprisingly been found that the inventive sliding element provides a high hardness, a low friction coefficient as well as a high chipping and scuffing resistance.

Furthermore, it has surprisingly been found that the inventive sliding element also provides a high wear resistance as well as a high delamination resistance.

Moreover, it has surprisingly been found that the detachment of small parts can be prevented in the inventive sliding element, leading to a prevention of scratches, for instance, on the cylinder liner.

In particular, this is achieved by applying a protective coating comprising at least one functional layer comprising or consisting of an alloy of nitrides, the alloy of nitrides comprising or consisting of a nitride solid solution and a nitride-containing multicomponent alloy, wherein the nitride solid solution comprises, based on the total nitride solid solution, at least about 35 at-% of Chromium and at least about 40 at-% of Nitrogen, and wherein the nitride-containing multicomponent alloy is a high-entropy alloy comprising at least about 40 at-% of Nitrogen based on the total nitride-containing multicomponent alloy, and at least four elements selected from the group consisting of Cr, Al, Si, W, Mo, Zr, Ti, Ni, Fe, Co, Nb, Ce, and B.

The functional layer of the protective coating either comprises the alloy of nitrides or consists thereof. Preferably, the functional layer consists of the alloy of nitrides.

One component of the alloy of nitrides is a nitride solid solution, comprising, based on the total nitride solid solution, at least about 35 at-% of Chromium and at least about 40 at-% of Nitrogen. A solid solution is a homogeneous mixture of at least two different kinds of atoms in solid state and having a single crystal structure. In the present invention, the nitride solid solution may contain only Chromium and Nitrogen but may additionally also contain one or more elements selected from the group consisting of Al, Si, W, Mo, Zr, Ti, Ni, Fe, Co, Nb, Ce, and B. Preferably, the nitride solid solution contains Chromium, Nitrogen and one additional element selected from the aforementioned group. Preferably, the one additional element is Al or Si.

Another component of the alloy of nitrides is a nitride-containing multicomponent alloy which is a high-entropy alloy comprising at least about 40 at-% of Nitrogen based on the total nitride-containing multicomponent alloy, and at least four elements selected from the group consisting of Cr, Al, Si, W, Mo, Zr, Ti, Ni, Fe, Co, Nb, Ce, and B. High-entropy alloys have initially been introduced in powder metallurgy for the production of alloys and attracted attention due to their special properties caused by a stabilization effect of the entropy of mixing. For instance, high-entropy ceramics have been described as solid solutions based on interstitial phases such as carbides, borides and silicides and usually contain four or more metallic species. The nitride-containing high-entropy alloys of the present invention comprise at least five different chemical elements (Nitrogen and at least four other (metal or semi-metallic (metalloid)) elements). The high entropy is based on the lowering of the Gibbs Free Energy of a phase due to the increased entropy of a solid solution phase with a large number of (for instance, at least five) randomly distributed components.

The alloy of nitrides may comprise the nitride solid solution and the nitride-containing multicomponent alloy, or may consist of the nitride solid solution and the nitride-containing multicomponent alloy. Preferably, the alloy of nitrides consists of the nitride solid solution and the nitride-containing multicomponent alloy.

High-entropy alloys based on nitrides have reportedly been produced as thin films. However, no protective layers based on alloys of nitrides comprising high-entropy alloy nitrides for the application in piston rings have been reported so far nor the production of layers with thicknesses higher than 10 µm applied by physical vapor deposition using a cathodic arc process.

Hereinafter, the invention is specified in more detail. Explanations and descriptions used in the context of the explanation of the inventive sliding element and the related Figures also apply to the inventive method to prepare the sliding element and the related Figures and vice versa.

According to the present invention, a sliding element for use in an internal combustion engine is provided. Such a sliding element may, for instance, be, but is not limited to, a piston ring. Alternatively, the sliding element may, for instance, also be a bearing, an engine cylinder or other components of internal combustion engines requiring sliding properties. The sliding element comprises a metallic base. In principle, all metallic bases known to a person skilled in the art may be applied.

Piston rings for combustion engine pistons are used to offset the inevitable gap between the piston and the cylinder wall. Thus, they provide an efficient sealing during operation of the engine and prevent combustion gases from escaping from the cylinder as well as the lubricant from assessing the combustion chamber. Due to the high stress a piston ring is usually exposed to during operation, a high resistance to wear and tear as well as chemical corrosion is required.

Therefore, according to the present invention the metallic base is at least partly covered with a protective coating. It is self-evident that the protective coating is advantageously applied to the outer surface exposed to the above-mentioned forces and chemical corrosion. Preferably, the whole outer surface exposed to the above-mentioned forces and chemical corrosion is covered with the protective coating. According to the invention, the protective coating comprises at least one adhesive layer and at least one functional layer. Consequently, the protective coating may comprise one adhesive layer, but it may also comprise two or more adhesive layers. Preferably, it comprises one adhesive layer. Analogously, the protective coating may comprise one functional layer, but it may also comprise two or more functional layers. Preferably, it comprises one functional layer. According to the invention, the at least one adhesive layer is located between the metallic base and the at least one functional layer, and it comprises at least one metal. The at least one adhesive layer provides a good cohesion between the base and the at least one functional layer. Moreover, according to the invention the at least one functional layer comprises or consists of an alloy of nitrides, the alloy of nitrides comprising or consisting of a nitride solid solution and a nitride-containing multicomponent alloy, wherein the nitride solid solution comprises, based on the total nitride solid solution, at least about 35 at-% of Chromium and at least about 40 at-% of Nitrogen, and wherein the nitride-containing multicomponent alloy is a high-entropy alloy comprising at least about 40 at-% of Nitrogen based on the total nitride-containing multicomponent alloy, and at least four elements selected from the group consisting of Cr, Al, Si, W, Mo, Zr, Ti, Ni, Fe, Co, Nb, Ce, and B. This leads to a high hardness, low friction coefficient and a high chipping and scuffing resistance. It has surprisingly been found that as a result of the inventive protective coating, also the interdiffusion at the grain boundaries is reduced, preventing crack initiation, crack deformation as well as crack propagation.

In an advantageous further development of the inventive sliding element, the at least one functional layer comprises about 45 to about 75 wt.-% of the nitride solid solution and about 25 to about 55 wt.-% of the nitride-containing multicomponent alloy; with wt.-% being based on the total weight of the at least one functional layer.

In an advantageous further development of the inventive sliding element, the alloy of nitrides comprises nitrides that are at least in part nanocrystalline. Surprisingly, it has been found that this further increases the wear resistance. A nanocrystalline material is a polycrystalline material with a crystallite size of only a few nanometers. These materials fill the gap between amorphous materials without any long-range order. Nanocrystalline material is commonly defined as a crystallite (grain) size below about 100 nm. The crystallite size of a nanocrystalline sample can be determined by preparing cross-sections of the at least one functional layer comprising or consisting of the alloy of nitrides. Subsequently, the crystallite size of the nanocrystals in the cross-sections is measured directly by using transmission electron microscopy (TEM).

Preferably, the alloy of nitrides comprises nitrides that are at least in part nanocrystalline with crystallite sizes below about 100 nm.

Moreover, in another advantageous further development of the inventive sliding element, the at least one functional layer comprises, in addition to Nitrogen, at least four elements selected from the group consisting of Cr, Al, Si, W, Mo, Zr, Ti, Ni, Fe, Co, Nb, Ce, and B, with a content as follows:
Cr: minimum about 10 at-% to maximum about 40 at-%,
Al: minimum about 1 at-% to maximum about 10 at-%,
Si: minimum about 2 at-% to maximum about 8 at-%,
W: minimum about 1 at-% to maximum about 5 at-%,
Mo: minimum about 0.1 at-% to maximum about 3 at-%,
Zr: minimum about 0.5 at-% to maximum about 15 at-%,
Ti: minimum about 5 at-% to maximum about 20 at-%,
Ni: minimum about 1 at-% to maximum about 8 at-%,
Fe: minimum about 1 at% to maximum about 15 at-%,
Co: minimum about 3 at-% to maximum about 10 at-%,
Nb: minimum about 1 at-% to maximum about 8 at-%,
Ce: minimum about 1 at-% to maximum about 5 at-%,
B: minimum about 0.2 at% to maximum about 4 at-%; with at-% being based on the total functional layer, respectively.

Surprisingly, it has been found that this leads to a high hardness, high temperature resistance, wear resistance, and corrosion resistance.

The chemical composition of the layers may, for instance, be analyzed using Scanning Electron Microscopy [Elemental analysis and quantification by EDS (Energy Dispersive X-ray Spectroscopy) or WDX (Wavelength-Dispersive X-ray spectroscopy)] or even Scanning Transmission Electron Microscopy.

In another advantageous further development of the inventive sliding element, at least two of the at least four elements selected from the group consisting of Cr, Al, Si, W, Mo, Zr, Ti, Ni, Fe, Co, Nb, Ce, and B of the nitride-containing multicomponent alloy are at least partly present as nitrides.

The presence of at least two of the at least four elements in the form of nitrides provides an outstanding hardness and fracture toughness.

Furthermore, it is preferred that the at least one adhesive layer comprises at least one element selected from the group consisting of chromium, nickel, titanium, and cobalt. Preferably, the at least one adhesive layer comprises chromium.

In this manner, an especially good adhesion on the metallic base can be achieved.

Moreover, in another advantageous further development of the inventive sliding element the protective coating additionally comprises at least one intermediate layer and the said at least one intermediate layer is situated between the at least one adhesive layer and the at least one functional layer. Consequently, the protective coating may comprise one intermediate layer, but it may also comprise two or more intermediate layers. Preferably, the protective coating comprises one intermediate layer. Moreover, it is preferred that the protective coating comprises one intermediate layer and one adhesive layer and the one intermediate layer is situated between the one adhesive layer and the at least one functional layer. The at least one intermediate layer may act as a cushion between the at least one adhesive layer and the at least one functional layer in order to prevent internal stress as well as interdiffusion between the layers. For instance, it is possible that a nitride layer may be deposited by Physical Vapor Deposition (PVD). Preferably, the at least one intermediate layer comprises CrN. Alternatively, it is preferred that the at least one intermediate layer comprises TiN. As another advantageous alternative, the intermediate layer comprises CrN and TiN.

Furthermore, it is preferred that the at least one adhesive layer and/or the at least one functional layer are applied via Physical Vapor Deposition (PVD), more preferably, the vapor is produced via a Cathodic Arc. Preferably, both the at least one adhesive layer and the at least one functional layer are applied via PVD, preferably via PVD wherein the vapor is produced via a Cathodic Arc. It is to be understood that if at least one intermediate layer is present, the at least one intermediate layer may also be applied via PVD, preferably via PVD wherein the vapor is produced via a Cathodic Arc.

Physical Vapor Deposition (PVD) comprises a variety of vacuum deposition methods which allow the production of thin films and coatings. During PVD, the material which is to be deposited transitions from a condensed phase to a vapor phase and then to a thin film condensed phase. Cathodic Arc (Arc-PVD) Process utilizes an electric arc to vaporize material from a target, which acts as cathode. At the small emitting area (cathode spot) extremely high local temperatures can be reached and cathode material is ejected with high velocity. It is also possible to influence the arc by applying an electromagnetic field or to rotate the cathode during deposition. The deposition of the layers by PVD and especially by Arc-PVD for instance allows for a fine-tuning of the deposited particles and thus, of the properties of the films in order to avoid stresses and to increase wear resistance.

It is furthermore preferred that the protective coating has a thickness of about minimum 10 µm to about maximum 60 µm, measured perpendicular to the surface of the sliding element. The thickness of the protective coating is composed of the thickness of the at least one adhesive layer, the at least one functional layer, and optionally, the at least one intermediate layer.

In this context, the thickness of the at least one adhesive layer is preferably between about minimum 0.5 µm to about maximum 3 µm. A typical thickness of the at least one adhesive layer is about 1 µm. Moreover, in this context, the thickness of the optional intermediate layer is preferably between about minimum 3 µm and about maximum 8 µm. A typical thickness of the optional intermediate layer is about 5 µm. Furthermore, the thickness of the functional layer is preferably between about minimum 25 µm to about maximum 59.5 µm.

Consequently, as an example, for a protective coating with an adhesive layer of 1 µm, an intermediate layer of 5 µm and a functional layer of 35 µm, a total thickness of the protective coating of 41 µm is obtained. For instance, such layer thicknesses may be measured by cross-sections analysis or Calotest evaluation.

It is preferred that the metallic base is a ferrous base. This means that the base comprises iron as a main component. It is furthermore preferred that the ferrous base comprises cast iron. As an alternative, it is preferred that the ferrous base comprises stainless steel comprising about minimum 10 wt.-% to about maximum 17 wt.-% of Chromium, based on the total weight of the stainless steel. As a further alternative, it is preferred that the ferrous base comprises carbon steel. Moreover, in this context, the ferrous base preferably comprises stainless steel which preferably comprises about minimum 13 wt.-% to about maximum 17 wt.-% of Chromium, based on the total weight of the stainless steel.

In a further advantageous development of the invention, the metallic base has received a nitriding treatment, i.e., is gas nitrided, at least on a part of its outer surface, preferably, the metallic base comprises gas nitrided stainless steel.

A person skilled in the art knows how to nitride a metallic base. For instance, a metallic base consisting of steel may be exposed to nitrogen at a temperature of, for instance, 500 °C during 1 hour to several hours. This leads to a hardened and resistant layer at the surface of the material. The process time and consequently the nitride layer thickness is dependent on the required application of the sliding element. In the case of piston rings, the nitride layer is preferably thicker for heavy duty applications than for light vehicles applications due to the engine demands. A typical thickness of the nitride layer for an upper compression ring is, e.g., 100 µm (± 20 µm) and a typical time for producing this layer is, e.g., 8 hours (± 1.5 h).

It is preferred that the sliding element is a piston ring.

The present invention also relates to a method for preparing a sliding element as described above, comprising the following steps:
i) Pre-cleaning of at least one sliding element comprising a metallic base,
ii) Loading the at least one sliding element comprising a metallic base into the PVD chamber,
iii) Applying a vacuum to the PVD chamber and maintaining the vacuum, preferably the vacuum is maintained at about minimum 0.1 Pa to about maximum 9.0 Pa,
iv) Heating the at least one sliding element comprising a metallic base, preferably the at least one sliding element comprising a metallic base is heated to about minimum 300 °C to about maximum 500 °C,
v) Optionally, ion bombardment of the at least one sliding element comprising a metallic base for further surface cleaning,
vi) depositing at least one adhesive layer,
vii) adding a reactive gas flow comprising nitrogen, preferably the reactive gas flow is set to about minimum 1000 standard cubic centimeters per minute (sccm) to about maximum 2200 sccm,
viii) depositing at least one functional layer.

The steps of preparation and deposition as listed above are described in more detail hereinafter.

First, in step i), at least one sliding element comprising a metallic base is pre-cleaned before being loaded into the PVD chamber. For instance, this may be done using a solvent. Suited solvents are known to the person skilled in the art. For instance, a suited solvent is acetone or tert-butyl acetate. Then, in step ii), the at least one sliding element comprising a metallic base is loaded into the PVD chamber. Subsequently, in step iii), a vacuum is applied to the PVD chamber and maintained. Preferably the vacuum is maintained at about minimum 0.1 Pa to about maximum 9.0 Pa. Then, in step iv), the at least one sliding element comprising a metallic base is heated, preferably the at least one sliding element comprising a metallic base is heated to about minimum 300 °C to about maximum 500 °C.

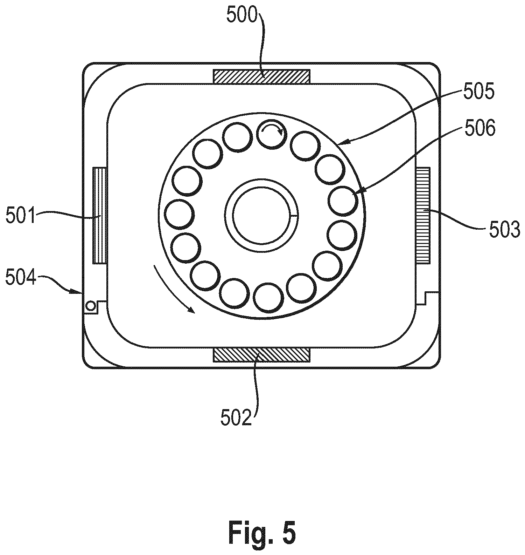

After step iv), optionally, in step v) the at least one sliding element comprising a metallic base may be further surface-cleaned by ion bombardment. This is especially advantageous when the at least one sliding element comprises a ferrous base. Following step iv) or v), in step vi), at least one adhesive layer is deposited. Preferably, the at least one adhesive layer comprises at least one element selected from the group consisting of chromium, nickel, titanium, and cobalt, preferably, the at least one adhesive layer comprises chromium. It is possible that one adhesive layer is deposited, but it is also possible that two or more adhesive layers are deposited. Preferably, one adhesive layer is deposited. Advantageously, the thickness of the at least one adhesive layer is between about minimum 0.5 µm to about maximum 3 µm. Moreover, preferably, a cathodic arc is applied as source for the material to be deposited. In this context, the material to be deposited is provided as a cathode wall. A table in the center of the PVD chamber can be rotated at varying speed. After step vi), a reactive gas flow comprising nitrogen is added in step vii). Preferably, the reactive gas flow comprises 99 wt.-% nitrogen, more preferably, the reactive gas flow comprises 99.9 wt.-% nitrogen, with wt.-% being based on the total weight of the reactive gas, respectively. Moreover, preferably, the reactive gas flow is set to about minimum 1000 standard cubic centimeters per minute (sccm) to about maximum 2200 sccm. Then, in step viii), at least one functional layer is deposited. This means it is possible that one functional layer is deposited, but it is also possible that two or more functional layers are deposited. Preferably, one functional layer is deposited. The at least one functional layer comprises or consists of an alloy of nitrides, the alloy of nitrides comprising or consisting of a nitride solid solution and a nitride-containing multicomponent alloy, wherein the nitride solid solution comprises, based on the total nitride solid solution, at least about 35 at-% of Chromium and at least about 40 at-% of Nitrogen, and wherein the nitride-containing multicomponent alloy is a high-entropy alloy comprising at least about 40 at-% of Nitrogen based on the total nitride-containing multicomponent alloy, and at least four elements selected from the group consisting of Cr, Al, Si, W, Mo, Zr, Ti, Ni, Fe, Co, Nb, Ce, and B. Preferably, a cathodic arc is applied as source. The deposition of the multi-component coating is possible using several cathode walls with different elements or combinations of elements and by varying the rotation speed (see also Figure 5). The targets may be diametrically distributed along the inner walls of the PVD chamber. The deposition of the at least one functional layer is preferably carried out under constant process conditions. Preferably, BIAS between about minimum 10 V and about maximum 50 V are applied.

In a further advantageous development of the inventive method for preparing a sliding element, between step vii) and step viii) a further step vii)-a) is comprised:
vii)-a) depositing at least one intermediate layer.

This means that instead of the deposition of the at least one functional layer in step viii) directly on the at least one adhesive layer obtained in step vi), at least one intermediate layer is deposited on the at least one adhesive layer. Consequently, the at least one functional layer is deposited in step viii) on top of the at least one intermediate layer obtained in step vii)-a). This can for instance also be done via cathodic arc PVD. It is possible that one intermediate layer is deposited, but it is also possible that two or more intermediate layers are deposited. Preferably, one intermediate layer is deposited. It is preferred that the at least one intermediate layer comprises CrN. Alternatively, it is preferred that the at least one intermediate layer comprises TiN. Moreover, as another advantageous alternative, the at least one intermediate layer comprises CrN and TiN.

The present invention further relates to an internal combustion engine, comprising at least one sliding element as described above.

Further features and advantages of the invention result from the subclaims, from the drawings and the corresponding figure description.

It should be understood that the scope of the present invention encompasses not only the variations as explained above and to be explained below, but also other possible combinations thereof.
- Fig. 1:: Schematic drawing of a piston for an internal combustion engine comprising piston rings.
- Fig. 2:: Schematic drawing of a configurative variation of the piston ring, installed in the piston channel.
- Fig. 3:: Schematic drawing of a preferred embodiment of the layers of the protective coating of a piston ring.
- Fig. 4:: Flowchart illustrating the steps of the inventive method for preparing a sliding element.
- Fig. 5:: Schematical drawing of a PVD chamber used for the deposition of multi component coatings.

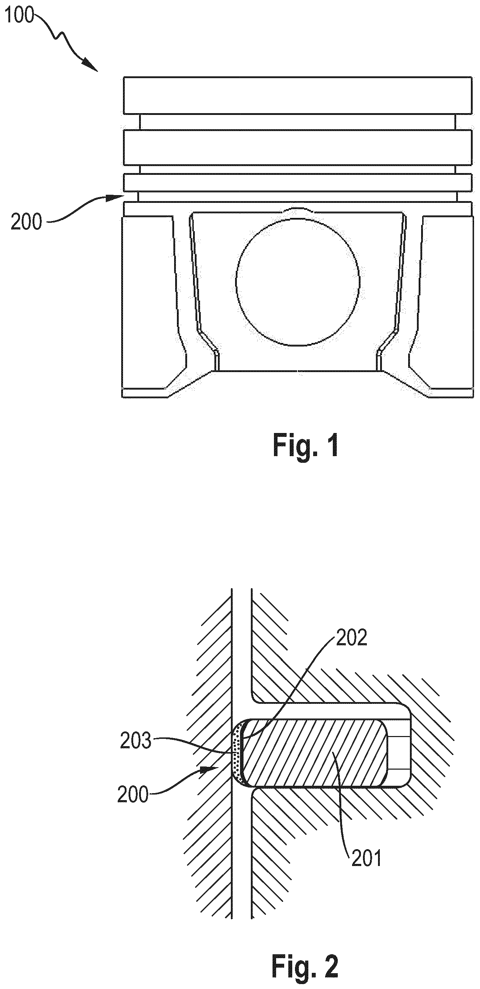

Figure 1 exemplary illustrates a piston 100 normally used in internal combustion engines comprising three piston rings 200.

Figure 2 exemplary shows a configurative variation of the piston ring 200, installed in the piston groove. The base is a metallic base 201, preferably it is a ferrous base. Especially, it is preferred that the base comprises cast iron, stainless steel comprising about minimum 10 wt.-% to about maximum 17 wt.-% chromium, based on the total weight of the stainless steel, or carbon steel. Additionally, it is preferred that the metallic base has received a nitriding treatment at least on a part of its outer surface. Furthermore, on the outer surface of the ring a protective coating is located, comprising at least one adhesive layer 202 and at least one functional layer 203. The at least one functional layer comprises or consists of an alloy of nitrides, the alloy of nitrides comprising or consisting of a nitride solid solution and a nitride-containing multicomponent alloy, wherein the nitride solid solution comprises, based on the total nitride solid solution, at least about 35 at-% of Chromium and at least about 40 at-% of Nitrogen, and wherein the nitride-containing multicomponent alloy is a high-entropy alloy comprising at least about 40 at-% of Nitrogen based on the total nitride-containing multicomponent alloy, and at least four elements selected from the group consisting of Cr, Al, Si, W, Mo, Zr, Ti, Ni, Fe, Co, Nb, Ce, and B.

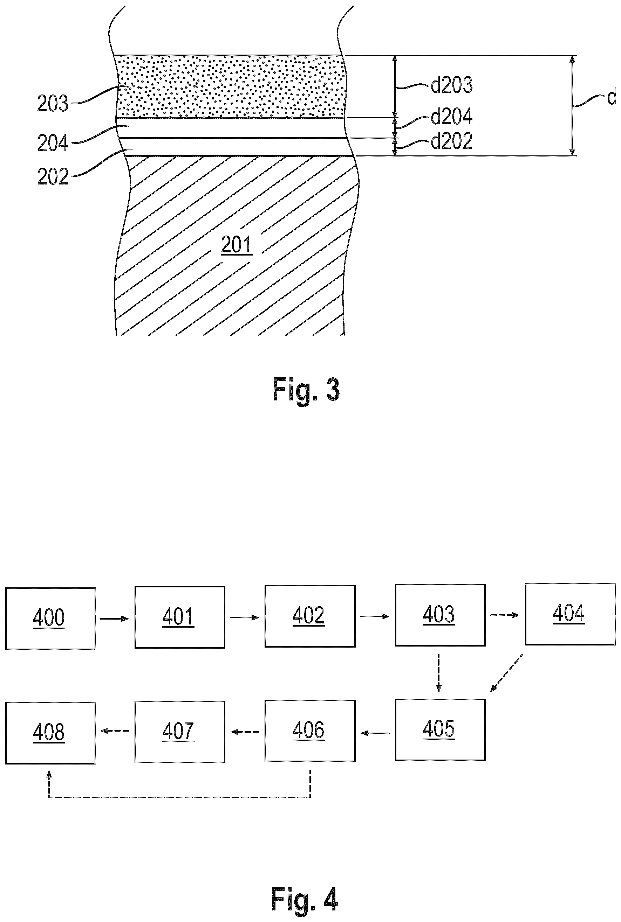

Figure 3 schematically illustrates an advantageous layer structure of the protective coating. Additionally, to the metallic base 201, the at least one adhesive layer 202 and the at least one functional layer 203, which are also shown in Figure 2, the advantageous configuration illustrated in Figure 3 also contains at least one intermediate layer 204 between the at least one adhesive layer 202 and the at least one functional layer 203. Preferably, the at least one intermediate layer 204 comprises CrN and/or TiN. Figure 3 also illustrates the thickness d of the total protective coating, which is composed by the sum of the thickness of the at least one adhesive layer d₂₀₂, the thickness of the at least one intermediate layer d₂₀₄ and the thickness of the at least one functional layer d₂₀₃. In an embodiment that does not comprise an intermediate layer, the thickness d of the total protective coating is composed only by the sum of the thickness of the at least one adhesive layer d₂₀₂ and the thickness of the at least one functional layer d₂₀₃. Preferably, the thickness d of the total protective coating is about minimum 10 µm to about maximum 60 µm, the thickness of the at least one adhesive layer is preferably between about minimum 0.5 µm to about maximum 3 µm, and the thickness of the optional intermediate layer is preferably between about minimum 3 µm and about maximum 8 µm. Furthermore, the thickness of the at least one functional layer is preferably between about minimum 25 µm to about maximum 59.5 µm.

Figure 4 schematically illustrates the steps of the inventive method for preparing a sliding element. In step i), at least one sliding element is pre-cleaned 400 and then loaded into the PVD chamber 401 in step ii). Afterwards, in step iii), a vacuum is applied to the PVD-chamber and maintained 402. Subsequently, in step iv), the at least one sliding element is heated 403. Optionally, it is possible that an ion bombardment is carried out 404 in step v) for further surface cleaning. Then, after step iv) or v) in step vi), at least one adhesive layer is deposited 405. In step vii), a reactive gas flow comprising nitrogen is added 406. Subsequently, it is optionally thinkable that in step vii)-a) at least one intermediate layer is deposited on top of the at least one adhesive layer 407. Following step vii) or step vii)-a), at least one functional layer is deposited 408 in step viii) either on top of the at least one adhesive layer or on top of the at least one intermediate layer.

In this context, what has been said previously regarding the steps of the production method also applies to the steps shown in Figure 4.

Figure 5 schematically illustrates a top view of Cathodic Arc PVD Chamber 504 as applied during the inventive method. Here, several target elements, schematical nominated as "A-element" target 500, "B-element" target 501, "C-element" target 502, and "D and E-element" target 503 are depicted. In the Arc-PVD applied during the inventive method, the targets act as cathodes. Depending on the desired composition, the different elements, such as, for instance, several elements selected from Cr, Al, Si, W, Mo, Zr, Ti, Ni, Fe, Co, Nb, Ce and B, can be provided as target. It is also possible to provide two or more elements within one single target. The cathodes (targets) are located at different walls of the PVD chamber 504 and are each provided with their own power supply. The sliding element to be coated may be provided on the table 505 in the middle of the chamber on the illustrated spindles 506. The table may rotate at a chosen speed (one or two fold rotation), which may also be varied during the method. The rotating speed controls the time the substrate passes in front of each target in such a way that it leads to the formation of coatings with different compositions ensuring a controlled cross contamination between the targets. The average deposition rate for all the depositions can, for instance, be chosen as 5 µm/h. Furthermore, the nitrogen pressure during the deposition of the at least one optional intermediate layer as well as the at least one functional layer is provided by providing a reactive gas flow comprising nitrogen, preferably, the reactive gas flow is set to about minimum 1000 standard cubic centimeters per minute (sccm) to about maximum 2200 sccm. Moreover, BIAS between about minimum 10 V and about maximum 50 V are applied.

### Reference Character List

- 100:: Piston
- 200:: Piston ring
- 201:: Metallic base
- 202:: At least one adhesive layer
- 203:: At least one functional layer
- 204:: At least one intermediate layer
- d:: Thickness of the total protective coating
- d₂₀₂:: Thickness of the at least one adhesive layer
- d₂₀₃:: Thickness of the at least one functional layer
- d₂₀₄:: Thickness of the at least one intermediate layer
- 400:: Pre-cleaning of the at least one sliding element
- 401:: Loading of the at least one sliding element
- 402:: Applying a vacuum to the PVD chamber
- 403:: Heating of the at least one sliding element
- 404:: Ion bombardment
- 405:: Deposition of at least one adhesive layer
- 406:: Adding a reactive gas flow comprising nitrogen
- 407:: optionally, depositing at least one intermediate layer
- 408:: Deposition of at least one functional layer
- 500:: "A-element" target
- 501:: "B-element" target
- 502:: "C-element" target
- 503:: "D-and E-element" target
- 504:: PVD chamber
- 505:: Table
- 506:: Spindle

## Claims

1. A sliding element for use in an internal combustion engine, comprising a metallic base which is at least partly covered with a protective coating, with the protective coating comprising at least one adhesive layer and at least one functional layer, **characterized in that**:
(i) the at least one adhesive layer is situated between the metallic base and the at least one functional layer,
(ii) the at least one adhesive layer comprises at least one metal, and
(iii) the at least one functional layer comprises or consists of an alloy of nitrides, the alloy of nitrides comprising or consisting of a nitride solid solution and a nitride-containing multicomponent alloy, wherein the nitride solid solution comprises, based on the total nitride solid solution, at least about 35 at-% of Chromium and at least about 40 at-% of Nitrogen, and wherein the nitride-containing multicomponent alloy is a high-entropy alloy comprising at least about 40 at-% of Nitrogen based on the total nitride-containing multicomponent alloy, and at least four elements selected from the group consisting of Cr, Al, Si, W, Mo, Zr, Ti, Ni, Fe, Co, Nb, Ce, and B.

2. The sliding element according to claim 1, **characterized in that** the at least one functional layer comprises about 45 to about 75 wt.-% of the nitride solid solution and about 25 to about 55 wt.-% of the nitride-containing multicomponent alloy; with wt.-% being based on the total weight of the at least one functional layer.

3. The sliding element according to one of claims 1 or 2, **characterized in that** the nitrides comprised in the alloy of nitrides are at least in part nanocrystalline.

4. The sliding element according to any one of claims 1 to 3, **characterized in that** the at least one functional layer comprises, in addition to Nitrogen, at least four elements selected from the group consisting of Cr, Al, Si, W, Mo, Zr, Ti, Ni, Fe, Co, Nb, Ce, and B, with a content as follows:
Cr: minimum about 10 at-% to maximum about 40 at-%,
Al: minimum about 1 at-% to maximum about 10 at-%,
Si: minimum about 2 at-% to maximum about 8 at-%,
W: minimum about 1 at-% to maximum about 5 at-%,
Mo: minimum about 0.1 at-% to maximum about 3 at-%,
Zr: minimum about 0.5 at-% to maximum about 15 at-%,
Ti: minimum about 5 at-% to maximum about 20 at-%,
Ni: minimum about 1 at-% to maximum about 8 at-%,
Fe: minimum about 1 at% to maximum about 15 at-%,
Co: minimum about 3 at-% to maximum about 10 at-%,
Nb: minimum about 1 at-% to maximum about 8 at-%,
Ce: minimum about 1 at-% to maximum about 5 at-%,
B: minimum about 0.2 at-% to maximum about 4 at-%; with at-% being based on the total functional layer, respectively.

5. The sliding element according to any one of claims 1 to 4, **characterized in that** at least two of the at least four elements selected from the group consisting of Cr, Al, Si, W, Mo, Zr, Ti, Ni, Fe, Co, Nb, Ce, and B are at least partly present as nitrides.

6. The sliding element according to any one of claims 1 to 5, **characterized in that** the at least one adhesive layer comprises at least one element selected from the group consisting of chromium, nickel, titanium, and cobalt.

7. The sliding element according to any one of claims 1 to 6, **characterized in that** the protective coating additionally comprises at least one intermediate layer and **in that** the at least one intermediate layer is situated between the at least one adhesive layer and the at least one functional layer, preferably, the at least one intermediate layer comprises CrN and/or TiN.

8. The sliding element according to any one of claims 1 to 7, **characterized in that** the at least one adhesive layer and/or the at least one functional layer are applied via physical vapor deposition (PVD), preferably, the vapor is produced via a cathodic arc.

9. The sliding element according to any one of claims 1 to 8, **characterized in that** the protective coating has a thickness of about minimum 10 µm to about maximum 60 µm, measured perpendicular to the surface of the sliding element.

10. The sliding element according to any one of claims 1 to 9, **characterized in that** the metallic base is a ferrous base.

11. The sliding element according to claim 10, **characterized in that** the ferrous base comprises
i) cast iron, or
ii) stainless steel comprising about minimum 10 wt.-% to about maximum 17 wt.-% chromium, based on the total weight of the stainless steel, or
ii) carbon steel; and/or
**characterized in that** the metallic base has received a nitriding treatment at least on a part of its outer surface, preferably, the metallic base comprises gas nitrided stainless steel.

12. The sliding element according to any one of claims 1 to 11, **characterized in that** the sliding element is a piston ring.

13. A method for preparing a sliding element according to any one of claims 1 to 12, comprising the following steps:
i) Pre-cleaning of at least one sliding element comprising a metallic base,
ii) Loading the at least one sliding element comprising a metallic base, into the PVD chamber,
iii) Applying a vacuum to the PVD chamber and maintaining the vacuum, preferably the vacuum is maintained at about minimum 0.1 Pa to about maximum 9.0 Pa,
iv) Heating the at least one sliding element comprising a metallic base, preferably the at least one sliding element comprising a metallic base is heated to about minimum 300 °C to about maximum 500 °C,
v) Optionally, ion bombardment of the at least one sliding element comprising a metallic base for further surface cleaning,
vi) depositing at least one adhesive layer,
vii) adding a reactive gas flow comprising nitrogen, preferably the reactive gas flow is set to about minimum 1000 standard cubic centimeters per minute (sccm) to about maximum 2200 sccm,
viii) depositing at least one functional layer.

14. The method according to claim 13, comprising furthermore a step:
vii) a) depositing at least one intermediate layer.

15. An internal combustion engine, comprising at least one sliding element according to any one of claims 1 to 12.
